# EUROPÄISCHE PATENTSCHRIFT

(11) **EP 0 538 432 B1**
(45) Veröffentlichungstag und Bekanntmachung des Hinweises auf die Patenterteilung: **27.09.1995**
(21) Anmeldenummer: 92909450.6
(22) Anmeldetag: 08.05.1992
(51) Int. Cl.: H05K 7/06, H01H 13/70

(54) **VORRICHTUNG ZUM HERSTELLEN EINER ELEKTRISCHEN SCHALTUNG, INSBESONDERE FÜR EINE MESSONDE UND MESSONDE**
DEVICE FOR PRODUCING AN ELECTRIC CIRCUIT, ESPECIALLY FOR A MEASURING PROBE, AND A MEASURING PROBE
DISPOSITIF POUR LA REALISATION D'UN CIRCUIT ELECTRIQUE, EN PARTICULIER POUR UNE SONDE DE MESURE, ET SONDE DE MESURE

(30) Priorität: 10.05.1991 CH 1404/91
(43) Veröffentlichungstag der Anmeldung: 28.04.1993
(73) Patentinhaber: BÖCK, Josef, CH-9427 Wolfhalden (CH)
(72) Erfinder: BÖCK, Josef, CH-9427 Wolfhalden (CH)
(74) Vertreter: Groner, Manfred
(86) Internationale Anmeldenummer: CH9200090
(87) Internationale Veröffentlichungsnummer: WO9221222

(56) Entgegenhaltungen:
- EP-A- 0 168 602
- WO-A-85/01913
- DE-B- 1 085 207
- DE-U- 8 901 047
- GB-A- 2 178 242
- US-A- 3 277 347

## Beschreibung

Die Erfindung betrifft eine Vorrichtung zum Herstellen einer elektrischen Schaltung, nach dem Oberbegriff des Anspruchs 1.

Der Erfindung liegt die Aufgabe zugrunde, eine Vorrichtung der genannten Art zu schaffen, mit der im wesentlichen durchsichtige Schaltungen sowie Messonden hergestellt werden können. Eine solche Schaltung soll auf grössere Anzeigen gelegt werden können, ohne dass das Hintergrundbild wesentlich gestört wird. Die Aufgabe ist gemäss Anspruch 1 gelöst.

Der Erfindung liegt der Gedanke zugrunde, dass aufgrund der Perfektion und Genauigkeit bei der Gewebeherstellung sehr exakte Drahtraster oder Raster mit optischen Leitern erzeugt werden können. Damit nun unter Zuhilfenahme von Geweben, die in einer Richtung wenigstens teilweise aus leitenden Drähten und in der anderen Richtung aus isolierenden Fäden bestehen, Schaltungen hergestellt werden können, sind Mittel vorgesehen, welche die Abstände wenigstens der leitenden Drähte fixieren. Ein wesentlicher Aspekt der Erfindung wird demnach darin gesehen, dass die Drähte in der genauen Anordnung fixiert sind, in welcher sie gewoben sind. Die Fixierung der leitenden Drähte oder Fäden kann auch allein durch die quer verlaufenden isolierenden Fäden gewährleistet sein.

Die Fixierung des Gewebes erfolgt gemäss Weiterbildung der Erfindung mit einem Lack oder mit einer auflaminierten masshaltigen Folie. Vorzugsweise ist die Folie mit Klebstoff beschichtet. Ist die Folie eine Isolationsfolie, so könnten Gewebe mit dazwischenliegenden Isolationsfolien um 90° zueinander verdreht aufeinandergelegt werden. Auf diese Weise kann kostengünstig und sehr genau eine X/Y-Matrix hergestellt werden. Die mit Klebstoff beschichteten Folien gewährleisten, dass die Gewebe mit hoher Präzision aufeinander liegen.

Auf der genannten Folie bzw. den Folien können mit leitenden Substraten Leiterbahnzüge aufgedruckt werden und mit den verschiedensten Techniken, beispielsweise mit Durchdrucken von Silberleitpasten durch Löcher in der Folie können zusätzliche Verbindungen in der Z-Achse zu den Drähten des Gewebes hergestellt werden. Damit lassen sich Schaltungen mit vielen Ebenen und hoher Packungsdichte und hoher Präzision herstellen.

Werden durchsichtige Folien verwendet, so können nahezu durchsichtige Schaltungen hergestellt werden, da auch dünnste und kaum sichtbare Gewebe verwendbar sind. Mit diesen Schaltungen können wiederum durchsichtige Anzeigen hergestellt werden, die partiell über grössere Anzeigen gelegt werden können, ohne dass das Hintergrundbild empfindlich gestört wird.

In der Elektronik war es bisher sehr schwierig, z.B. bei Lumineszenzbildschirmen die Chips anzuschliessen. Mit der Chip-on-film-Technik (COF) kann dieses Problem elegant gelöst werden, nämlich wie folgt:
a) Ein Wafer wird auf eine geätzte, mit sehr feinen Leiterbahnen versehene Folie aufgebracht. Die sehr feinen Leiterbahnen führen auf der Folie vom Wafer weg, auf eine Seite des Folienbandes. Die Leiterbahnabstände sind übereinstimmend mit den Gewebeabständen und sind vorbereitet für die Kontaktierung an das Gewebe einer erfindungsgemässen Vorrichtung.
b) Das auf einer Folie vorbereitete Gewebe bzw. das ganze Pakte der Anzeige wird so vorbereitet, dass es an die Chipfolie a) kontaktiert werden kann.

Mittels Ultraschall werden die Gewebedrähte der erfindungsgemässen Vorrichtung an die Kupferleitbahnen auf der Chipfolie befestigt (Ultraschall, Entladungsschweissung oder thermische Befestigung).

Das um 90° verdrehte, zweite Gewebe wird wiederum seitlich mit einem solchen Folienstreifen mit Wafern darauf kontaktiert. Somit entsteht ein in X und Y angesteuerter Bildschirm.

Soll eine höchste Auflösung erreicht, d.h. feinste Gewebe verwendet werden, so werden bei dem einen Gewebe an beiden gegenüberliegenden Seiten die Chips nur bei jedem zweiten Draht angeschlossen. Der dazwischenliegende Draht liegt frei und wird von der Gegenseite bedient. Somit werden zu erwartende Kurzschlüsse vermieden.

Der so hergestellte Bildschirm oder die Anzeige kann mit einer mit Displayfarben bedruckten Frontfolie versehen werden, die partiell offengehalten wird, damit nur die Anzeigefelder gesehen bzw. die Elektronik verdeckt ist.

Flachste Bildschirme mit der zugehörigen Elektronik sind somit möglich.

Diese Art von Bildschirmen sind durchsichtig.

Die verschiedenen, übereinanderliegenden Gewebe einer erfindungsgemässen Vorrichtung, mit der entsprechenden, auf der Seite "angenähten Elektronik" können vorteilhaft auch als Eingabe, wie sie bei Digitizern benötigt wird, verwendet werden. Dank der Nähe der Leiterbahnen zueinander ist es möglich, Digitizer mit hoher Auflösung zu bekommen. Mittels eines Stiftes können die beiden um 90° verdrehten, übereinanderliegenden Gewebe induktiv oder kapazitiv angesteuert werden. Die Auswertelektronik an der X- und Y-Seite erkennt den genauen Standort des Stiftes.

Es gibt heute verschiedenste Arten von Digitalisiertabletts, die mit Drähten arbeiten. Hierbei wurde jedoch kein Gewebe verwendet, das nur in einer Richtung leitende Drähte besitzt. Auch ist die Kombination mit der COF-Technik und direkter Kontaktierung der Drähte auf die Leiterbahnen der Filme nie realisiert worden.

Nach einem erfindungsgemässen Verfahren wird das Gewebe unmittelbar nach dem Weben auf eine mit Klebstoff beschichtete Folie auflaminiert. Hierzu eignet sich besonders eine Vorrichtung nach der WO 85/01913, bei welcher Folien mittels Abrollbewegungen miteinander verpresst werden. Damit können in X-und Y-Richtung hohe Genauigkeiten realisiert werden. Drähte und Fäden des Gewebes können so weniger verrutschen und das Gewebe kann mit grösserem Durchmesser aufgerollt werden. Da mit dieser Vorrichtung Folien und Gewebe in genauer relativer Ausrichtung miteinander verpresst werden können, ist es möglich, mehrere Folien und Gewebe übereinander anzuordnen. Wesentlich ist, dass die für die Kontaktierungen vorgesehenen Ausstanzungen oder Ausschnitte in den Folien genau über den Drähten der entsprechenden Gewebe angeordnet sind. Es hat sich gezeigt, dass auch bei sehr feinem Gewebe die erforderliche Genauigkeit bei Verwendung einer Vorrichtung nach der oben genannten Schrift erreicht werden kann.

Es ist jedoch wichtig, dass der entsprechende Drahtdurchmesser des Gewebes mit der entsprechenden Dicke der Folie und des Klebauftrages abgestimmt ist. Ansonsten entstehen unterschiedliche Längen beim Aufrollen, was einen Faltenwurf hervorruft. Bei Versuchen hat sich gezeigt, dass vorwiegend hochmasshaltige Polyesterfolien, die vorgetempert worden sind, verwendet werden.

Weitere vorteilhafte Merkmale ergeben sich aus den abhängigen Ansprüchen und der nachfolgenden Beschreibung.

Ausführungsbeispiele der Erfindung werden nachfolgend anhand der Zeichnung näher erläutert. Es zeigen:
Fig. 1 und 2 schematisch jeweils eine perspektivische Ansicht eines Ausschnittes einer erfindungsgemässen Vorrichtung,
Fig. 3a und 3b schematisch ein Verfahren zur Herstellung einer erfindungsgemässen Vorrichtung,
Fig. 4 und 5 Schnitte durch erfindungsgemässe Vorrichtungen,
Fig. 6 eine Draufsicht auf einen Abschnitt einer erfindungsgemässen Vorrichtung, mit einem angeschlossenen Verbindungsstecker, und
Fig. 7 eine schematische Ansicht einer Messonde.

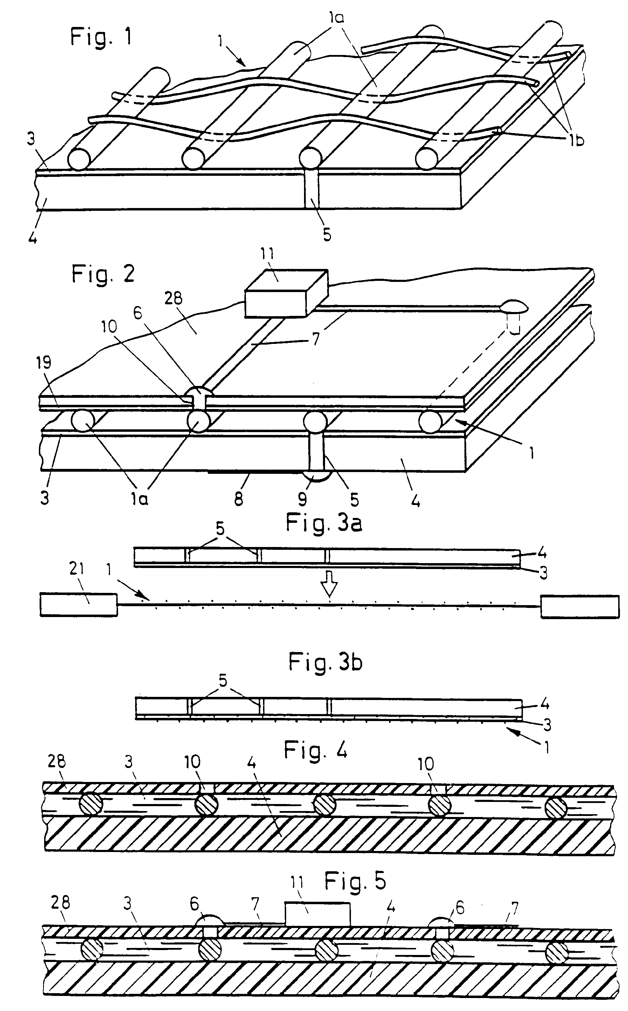

Die Figur 1 zeigt ein Gewebe 1 aus leitenden Drähten 1a und isolierenden Fäden 1b. Die Drähte 1a sind beispielsweise aus Kupfer, Gold oder einem anderen leitenden Werkstoff und die Fäden 1b aus Nylon. Ein solches Gewebe 1 kann in üblicher Weise gewoben werden, wobei die Abstände zwischen den Drähten 1a bzw. den Fäden 1b zwischen wenigen µ und einigen mm betragen können. Die Drähte 1a können jedoch teilsweise oder ausschliesslich optisch leitende Fäden oder Fasern sein.

Das Gewebe ist mit einer mit Klebstoff 3 beschichteten Isolationsfolie 4 fixiert. Die Folie 4 ist beispielsweise eine hochmasshaltige Polyesterfolie, die vorgetempert worden ist. Sie kann Ausstanzungen 5 aufweisen, damit an diesen Stellen das Gewebe 1 durch die Folie 4 hindurch elektrisch kontaktiert werden kann. Der Klebstoff 3 ist beispielsweise ein weicher, transparenter und flexibler Klebstoff mit einer hohen Anfangshaftung. Sollen die Drähte 1a nur oberflächlich aufliegen, wie dies vorwiegend bei Transferarbeiten benötigt wird, so wird vorzugsweise ein harter Klebstoff 3 verwendet.

Bei der Ausführung gemäss Fig. 2 ist das Gewebe 1, wie oben beschrieben, auf der Folie 4 aufgeklebt. Als weitere isolierende Schicht ist hier eine weitere, ebenfalls hoch durchsichtige und flexible Folie 28, die ebenfalls an genau bestimmten Stellen Ausstanzungen 10 aufweist, auflaminiert.. Die Folie 28 weist auf ihrer Unterseite ebenfalls eine Klebstoffschicht 9 auf.

Auf die Folien 4 und 28 sind in an sich bekannter Weise Leiterbahnen 7 bzw. 8 aufgebracht und diese sind durch die Folien 4 und 28 hindurch mit Drähten 1a des Gewebes 1 elektrisch verbunden. Diese in Z-Richtung laufenden Verbindungen 6 bzw. 9 zwischen den Leiterbahnen 7 bzw. 8 und Drähten 1a können beispielsweise mit Silberleitpaste hergestellt werden, die in die Ausstanzungen 5 bzw. 10 eingebracht werden.

Die Leiterbahnen 7 sind mit einem elektrischen Bauelement 11 verbunden, das auf der Oberseite der Folie 28 angebracht ist. Das Bauelement 11 ist beispielsweise eine Diode oder ein Sensor, jedoch sind hier je nach Verwendung der Vorrichtung auch andere an sich bekannte elektrische Bauelemente denkbar. Die Leiterbahn 8 führt zu einem hier nicht gezeigten, auf der Folie 28 angebrachten Bauelement. In der in Fig. 2 gezeigten Ausführung sind auf beiden Folien 4 und 28 Leiterbahnen und Bauelemente angebracht. Es sind jedoch auch Ausführungen vorgesehen, bei denen nur auf einer Folie, beispielsweise auf der Folie 4, Leiterbahnen 8 und Bauelemente angebracht sind.

Zur Fixierung des Gewebes 1 wird die mit Ausstanzungen 5 und der Klebstoffsicht 3 versehene Folie 4 bereits dann mit dem Gewebe 1 verbunden, wenn dieses noch im Webrahmen 12 eingespannt ist, wie in Fig. 3a schematisch dargestellt. Damit kann sichergestellt werden, dass die nach dem Weben vorhandene genaue Ausrichtung der Drähte 1a und Fäden 1b erhalten bleibt und die Ausstanzungen 5 genau über den vorgesehenen Drähten 1a positioniert sind. Ist das Gewebe 1 mittels der Folie 4 fixiert, so kann dieses vom Rahmen 12 entfernt werden, so dass dann das Laminat gemäss Fig. 3b vorliegt.

Auf die noch freiliegende Seite des Gewebes 1 wird in einem weiteren Laminierungsvorgang die Folie 28 aufgebracht.

Die Fig. 4 und 5 zeigen im Schnitt Beispiele von Laminaten, bei denen nun die eine Folie 28 als Träger für Leiterbahnen 7 und Bauelemente 11 vorgesehen ist.

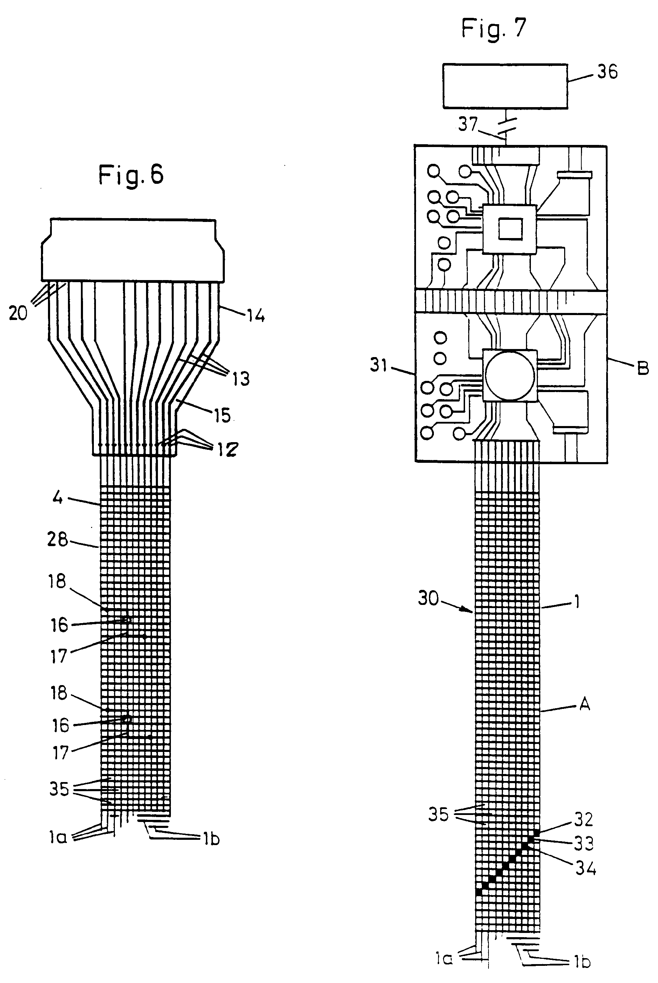

Die Drähte 1a sind am Rand des Laminates mittels Lötstellen 12 mit Leiterbahnen 13 eines Verbindungssteckers 14 verbunden, wie in Fig. 6 gezeigt. Die Leiterbahnen 13 sind hier auf eine flexible Folie 15 aufgebracht. Solche Stecker 14 sind bekannt. Die exakte Anordnung der Drähte 1b erlaubt eine einfache und automatische Herstellung der Lötstellen 12. Voraussetzung ist auch hier die Fixierung des Gewebes 1 und ein geeigneter Laminierungsvorgang. Bei der Ausführung nach Fig. 6 sind Leuchtdioden 16 über Leiterbahnen 17 und Verbindungsstellen 18 mit Drähten des Gewebes 1 und schliesslich mit Anschlussstellen 20 des Steckers 14 verbunden. Wie ersichtlich können bei der hier gezeigten einfachen Ausführung bereits zahlreiche Leichtdioden 16 einzeln versorgt werden.

Die Figur 7 zeigt eine Messonde 30, die einen Analysesubstratträger A aufweist, der elektrisch oder optisch mit einer Auswertschaltung B verbunden ist. Der Analysesubstratträger A weist ein streifenförmiges Gewebe 1 mit Gold, Kupfer oder anderen Metallfäden 1a in Kettrichtung und Polyester- oder Nylonfäden 1b in Schussrichtung auf. Das Gewebe 1 wird bereits während des Webvorganges fixiert, damit in den Abmessungen genau spezifizierte Maschenöffnungen 35 gewährleitst sind. Die oben erwähnten Massnahmen zur Fixierung des Gewebes 1 sind auch beim Analysesubstratträger möglich. Mit geeigneten Messern ist das Gewebe 1 auf die gewünschte Form geschnitten.

Im Analysebereich der Messonde 30 sind Maschenöffnungen des Gewebes 1 mit Analysesubstraten 32, 33 und 34 dotiert. Durch die an den dotierten Maschenöffnungen entlangführenden Drähten 1a ist der elektrische oder optische Anschluss nach aussen bzw. zur Auswertschaltung B und zu einer Anzeige oder einem Rechner 36 hergestellt. Durch die dotierten Maschen werden somit Analysezellen gebildet, die jeweils ihre eigenen Anschlüsse aufweisen. Die Analysesubstrate 32, 33 und 34 sind beispielsweise an sich bekannte Substrate, die ihren elektrischen Widerstand ändern, wenn sie mit einer Flüssigkeit in Berührung kommen, wobei die Widerstandsänderung von der Art der Flüssigkeit und ihrem Zustand abhängig ist. Die Analysesubstrate 32 bis 34 sind vorzugsweise unterschiedliche Substrate, die auf unterschiedliche Eigenschaften der zu messenden Flüssigkeit ansprechen. Wird der Analysesubstratträger A beispielsweise in eine zu messende Flüssigkeit getaucht, so können dann gleichzeitig mehrere Werte der Flüssigkeit bestimmt werden. Zur Auswertung sind die von den Analysesubstraten 32 bis 34 ausgehenden Drähte 1a direkt elektrisch leitend mit einem Wafer oder Chip 31 verbunden. Durch diesen werden in an sich bekannter Weise die codierten Signale über eine Zwei- oder Dreidrahtleitung 37 dem Rechner 36 zugeführt. Mit der Messonde 30 ist somit eine sehr präzise Vergleichsmesswerterfassung möglich, da mit der gleichen Messonde 30 mehrere verschiedene Messungen durchführbar sind. Die Messonde 30 lässt sich industriell in grossen Serien und damit kostengünstig herstellen. Die Messonde 30 eigent sich insbesondere für die Untersuchung von Gewebeflüssigkeiten beispielsweise von Blut.

Die leitenden Fäden 1a können auch optisch leitende Fäden oder Fasern, beispielsweise Glasfasern sein. Die Substrate 32 bis 34 sind dann beispielsweise Dioden, die auf Helligkeitsunterschiede oder andere optische Eigenschaften ansprechen. Die Fäden oder Fasern 1a leiten das von den Dioden ausgehende Licht zur Auswertschaltung B welche die optische Messwerte auswertet und beispielsweise anzeigt.

Die Messonde 30 kann auch Teil eines Katheters ein, der beispielsweise in ein Blutgefäss eingeführt werden kann und der an seinem distalen Ende mit den Analysesubstraten 32 bis 34 versehen ist. Das Gewebe 1 verbindet dann die Substrate 32 bis 34 mit einer am proximalen Ende des Katheters angeordneten Auswertschaltung B. Denkbar sind auch andere Anwendungen der Messonde 30, beispielsweise für Messungen in einer Gasphase.

Die Herstellung einer geeigneten Auswertschaltung B, sowohl elektronisch als auch optisch, ist für den Fachmann aufgrund seines Fachwissens möglich, weshalb hier auf eine detaillierte Beschreibung einer solchen Schaltung verzichtet werden kann.

## Patentansprüche

1. Vorrichtung zum Herstellen einer elektrischen Schaltung, insbesondere Messonde, mit einem Gewebe, das aus einer Vielzahl von länglichen Leitern (1a) und einer Vielzahl von länglichen Isolierfäden (1b) gewoben ist, wobei die Vielzahl von länglichen Leitern (1a) derart in das Gewebe (1) gewoben sind, dass sich alle Leiter (1a) in Längsrichtung und in einem seitlichen Abstand zueinander erstrecken, und wobei die Vielzahl von länglichen Isoliefäden (1b) derart in das Gewebe (1) gewoben sind, dass sie sich seitlich durch die Vielzahl von Leitern (1a) erstrecken, und den seitlichen Abstand zwischen den Leitern aufrechterhalten, dadurch gekennzeichnet, dass der seitliche Abstand der Vielzahl von Leitern (1a) durch eine Folienschicht (3,4) aufrechterhalten wird, die auf mindestens einer Seite des Gewebes (1) aufgetragen ist, dass die Folienschicht (3,4) mindestens ein Paar Löcher (5,10) aufweist, die sich durch die Folienschicht (3,4) erstrecken, wobei sich ein erstes Loch (5,10) zu einem ersten Leiter (1a) und ein zweites Loch (5,10) zu einem zweiten Leiter (1a) erstreckt, dass eine elektrische Komponente (11) auf der Folienschicht (3,4) fixiert ist, die durch die Folienschicht (3,4) von der Vielzahl von Leitern (1a) getrennt wird, und dass sich eine erste Leiterbahn (7) vom ersten Leiter durch das erste Loch (5,10) zur elektrischen Komponente (11) und eine zweite Leiterbahn (8) vom zweiten Leiter (1a) durch das zweite Loch zur elektrischen Komponente (11) erstreckt, wodurch die elektrische Komponente (11) mit dem ersten und mit dem zweiten Leiter in elektrischer Verbindung steht.

2. Vorrichtung nach Anspruch 1, dadurch gekennzeichnet, dass die elektrische Komponente (11) eine Diode ist.

3. Vorrichtung nach Anspruch 1 oder 2, dadurch gekennzeichnet, dass das Gewebe (1) auf eine hochmasshaltige Folie (4) auflaminiert ist.

4. Vorrichtung nach Anspruch 3, dadurch gekennzeichnet, dass die Folie (1) gewebeseitig mit Klebststoff (3) beschichtet ist.

5. Vorrichtung nach Anspruch 3 oder 4, dadurch gekennzeichnet, dass die Folie (4,28) eine vorgetemperte Polyesterfolie ist.

6. Vorrichtung nach einem der Ansprüche 4 oder 5, dadurch gekennzeichnet, dass der Klebstoff (3) hart ist, derart, dass die leitenden Drähte (1a) lediglich oberflächlich auf diesem aufliegen.

7. Vorrichtung nach einem der Ansprüche 1 bis 6, dadurch gekennzeichnet, dass wenigstens zwei Gewebe (1) mit einer dazwischenliegenden Isolationsschicht aufeinandergelegt sind.

8. Vorrichtung nach Anspruch 7, dadurch gekennzeichnet, dass die Gewebe (1) um 90° zueinander verdreht sind.

9. Vorrichtung nach einem der Ansprüche 1 bis 8, gekennzeichnet durch eine partiell ausgestanzte oder ausgeschnittene Folie (4,28), die mit dem Gewebe (1) verbunden ist, wobei die Ausstanzungen (5,10) bzw. die Ausschnitte wenigstens teilweise zur Herstellung von Kontakten zu den leitenden Drähten (1a) des Gewebes (1) geeignet sind.

10. Vorrichtung nach Anspruch 9, dadurch gekennzeichnet, dass die Leiterbahnen (7,8) wenigstens teilweise durch die Löcher (5,10) mit den leitenden Drähten (1a) des Gewebes (1) elektrisch verbunden sind.

11. Messonde, mit einer Vorrichtung gemäss Anspruch 1, dadurch gekennzeichnet, dass Maschenöffnungen des Gewebes mit Analysesubstraten dotiert sind und die elektrisch leitenden Drähte oder Fäden (1b) mit einer Auswertschaltung verbunden sind.

12. Sonde nach Anspruch 11, dadurch gekennzeichnet, dass jede mit einem Analysesubstrat dotierte Maschenöffnung eine Analysezelle mit eigenen Anschlüssen an der Auswertschaltung versehen ist, wobei die elektrische oder optische Verbindung durch elektrische oder optische Drähte oder Fäden des Gewebes hergestellt ist.

13. Sonde nach Anspruch 1, dadurch gekennzeichnet, dass an den dotierten Maschenöffhungen Widerstandswerte gemessen und diese in codierte Signale umgewandelt werden.

14. Sonde nach einem der Ansprüche 11 bis 13, dadurch gekennzeichnet, dass die elektrisch leitenden Drähte des Gewebes direkt elektrisch leitend mit einem Wafer (Chip) verbunden sind.

## Claims

1. Device for producing an electrical circuit, in particular a measurement probe, having a woven mesh which is woven from a large number of elongated conductors (1a) and a large number of elongated insulating threads (1b), the large number of elongated conductors (1a) being woven into the woven mesh (1) in such a manner that all the conductors (1a) extend in the longitudinal direction and with a lateral separation from one another, and the large number of elongated insulating threads (1b) being woven into the woven mesh (1) in such a manner that they extend laterally through the large number of conductors (1a) and maintain the lateral separation between the conductors, characterized in that the lateral separation between the large number of conductors (1a) is maintained by a film layer (3, 4) which is applied onto at least one side of the woven mesh (1), in that the film layer (3, 4) has at least one pair of holes (5, 10) which extend through the film layer (3, 4), a first hole (5, 10) extending to a first conductor (1a) and a second hole (5, 10) extending to a second conductor (1a), in that an electrical component (11) is fixed on the film layer (3, 4) and is isolated by the film layer (3, 4) from the large number of conductors (1a), and in that a first conductor track (7) extends from the first conductor through the first hole (5, 10) to the electrical component (11), and a second conductor track (8) extends from the second conductor (1a) through the second hole to the electrical component (11), as a result of which the electrical component (11) is electrically connected to the first conductor and to the second conductor.

2. Device according to Claim 1, characterized in that the electrical component (11) is a diode.

3. Device according to Claim 1 or 2, characterized in that the woven mesh (1) is laminated onto a highly dimensionally constant film (4).

4. Device according to Claim 3, characterized in that the film (1) is coated with adhesive (3) on the woven mesh side.

5. Device according to Claim 3 or 4, characterized in that the film (4, 28) is a pre-tempered polyester film.

6. Device according to one of Claims 4 or 5, characterized in that the adhesive (3) is cured in such a manner that the conductive wires (1a) lie only on the surface thereof.

7. Device according to one of Claims 1 to 6, characterized in that at least two woven meshes (1) are placed one on top of the other, with an insulation layer located in between them.

8. Device according to Claim 7, characterized in that the woven meshes (1) are rotated through 90° with respect to one another.

9. Device according to one of Claims 1 to 8, characterized by a partially stamped out or cut out film (4, 28) which is connected to the woven mesh (1), at least some of the stamped-out regions (5, 10) or the cut outs being suitable for producing contacts to the conductive wires (1a) of the woven mesh (1).

10. Device according to Claim 9, characterized in that at least some of the conductor tracks (7, 8) are electrically connected through the holes (5, 10) to the conductive wires (1a) of the woven mesh (1).

11. Measurement probe having a device according to Claim 1, characterized in that mesh openings in the woven mesh are doped with analysis substrates and the electrically conductive wires or threads (1b) are connected to an evaluation circuit.

12. Probe according to Claim 11, characterized in that each mesh opening which is doped with an analysis substrate is provided with an analysis cell having its own connections to the evaluation circuit, the electrical or optical connection being produced by means of electrical or optical wires or threads in the woven fabric.

13. Probe according to Claim 1, characterized in that resistance values are measured on the doped mesh openings and said resistance values are converted into coded signals.

14. Probe according to one of Claims 11 to 13, characterized in that the electrically conductive wires in the woven mesh are directly electrically conductively connected to a wafer (chip).

## Revendications

1. Dispositif pour fabriquer un circuit électrique, notamment une sonde de mesure, comportant un tissu, qui est formé par le tissage d'une multiplicité de long conducteurs (1a) et d'une multiplicité de longs fils isolants (1b), la multiplicité des longs conducteurs (1a) étant insérée dans le tissu (1) de telle sorte que tous les conducteurs (1a) s'étendent dans la direction longitudinale et à une certaine distance latérale réciproque, et la multiplicité de longs fils isolants (1b) étant insérée dans le tissu (1) de telle sorte qu'ils s'étendent latéralement à travers la multiplicité de conducteurs (1a) et maintiennent la distance latérale entre les conducteurs, caractérisé en ce que la distance de la multiplicité de conducteurs (1a) est maintenue par une couche en forme de feuille (3,4), qui est déposée sur au moins une face du tissu (1), que la couche en forme de feuille (3,4) comporte au moins un couple de trous (5,10), qui traversent la couche en forme de feuille (3,4), un premier trou (5,10) s'étendant jusqu'à un premier conducteur (1a) et un second trou (5,10) s'étendant jusqu'à un second conducteur (1a), que sur la couche en forme de feuille (3,4) est fixé un composant électrique (11) qui est séparé de la multiplicité de conducteurs (1a) par la couche en forme de feuille (3,4), et qu'une première voie conductrice (7) s'étend depuis un conducteur jusqu'au composant électrique (11) en traversant le premier trou (5,10) et qu'une seconde voie conductrice (8) s'étend depuis le second conducteur (1a) jusqu'au composant électrique (11) en traversant le second trou, les composants électriques (11) étant reliés électriquement aux premier et second conducteurs.

2. Dispositif selon la revendication 1, caractérisé en ce que le composant électrique (11) est une diode.

3. Dispositif selon la revendication 1 ou 2, caractérisé en ce que le tissu (1) est plaqué sur une feuille (4) qui a des dimensions très précises.

4. Dispositif selon la revendication 3, caractérisé en ce que la feuille (1) est recouverte, côté tissu, par un adhésif (3).

5. Dispositif selon la revendication 3 ou 4, caractérisé en ce que la feuille (4,28) est une feuille de polyester préalablement soumise à un recuit.

6. Dispositif selon l'une des revendications 4 ou 5, caractérisé en ce que l'adhésif (3) est dur de telle sorte que les fils conducteurs (1a) s'appliquent uniquement sur la surface de cet adhésif.

7. Dispositif selon l'une des revendications 1 à 6, caractérisé en ce qu'au moins deux tissus (1) sont superposés moyennant l'insertion intercalée d'une couche isolante.

8. Dispositif selon la revendication 7, caractérisé en ce que les tissus (1) sont pivotés réciproquement de 90°.

9. Dispositif selon l'une des revendications 1 à 8, caractérisé par une feuille (4,28) partiellement découpée ou sectionnée dans la matrice et qui est reliée au tissu (1), et les découpes (5,10) ou les ouvertures formées par sectionnement convenant au moins partiellement pour l'établissement de contacts avec les fils conducteurs (1a) du tissu (1).

10. Dispositif selon la revendication 9, caractérisé en ce que les voies conductrices (7,8) sont reliées électriquement au moins en partie à travers les trous (5,10) aux fils conducteurs (1a) du tissu (1).

11. Sonde de mesure comportant un dispositif selon la revendication 1, caractérisée en ce que les ouvertures des mailles du tissu sont équipées de substrats d'analyse et les fils ou des filaments électriquement conducteurs (1b) sont reliés à un circuit d'évaluation.

12. Sonde selon la revendication 11, caractérisée en ce que chaque ouverture de maille équipée d'un substrat d'analyse forme une cellule d'analyse comportant des bornes particulières de raccordement au circuit d'évaluation, la liaison optique ou électrique étant établie au moyen de fils ou filaments électriques ou optiques du tissu.

13. Sonde selon la revendication 1, caractérisée en ce que les valeurs résistives sont mesurées au niveau des ouvertures de mailles équipées et ces valeurs résistives sont converties en des signaux codés.

14. Sonde selon l'une des revendications 11 à 13, caractérisée en ce que les fils électriques conducteurs du tissu sont reliés directement d'une manière électriquement conductrice à une pastille (microplaquette).
